# EUROPEAN PATENT SPECIFICATION

(11) **EP 4 487 054 B1**
(45) Date of publication and mention of the grant of the patent: **21.10.2026**
(21) Application number: 23705589.2
(22) Date of filing: 22.02.2023
(51) Int. Cl.: F21K 9/23, F21Y 113/13, F21Y 115/10

(54) **LIGHT EMITTING DIODE FILAMENT HAVING REDUCED OPTICAL CROSS-TALK**
LEUCHTDIODENFADEN MIT REDUZIERTEM OPTISCHEM ÜBERSPRECHEN
FILAMENT DE DIODE ÉLECTROLUMINESCENTE À DIAPHONIE OPTIQUE RÉDUITE

(30) Priority: 03.03.2022 EP 22159891
(43) Date of publication of application: 08.01.2025
(73) Proprietor: Signify Holding B.V., 5656 AE Eindhoven (NL)
(72) Inventor: WEIJERS, Aldegonda Lucia, 5656 AE Eindhoven (NL); TER WEEME, Berend Jan Willem, 5656 AE Eindhoven (NL)
(74) Representative: Verweij, Petronella Daniëlle
(86) International application number: PCT/EP2023/054355
(87) International publication number: WO 2023/165855

(56) References cited:
- WO-A1-2022/233715
- US-A1- 2020 212 014

## Description

### FIELD OF THE INVENTION

The present invention relates to an LED (light emitting diode) filament providing reduced optical cross-talk. The present invention also relates to an LED filament lamp comprising at least one such LED filament. The present invention also relates to a method of manufacturing an LED filament.

### BACKGROUND OF THE INVENTION

A conventional tuneable white filament lamp consists of at least two filaments, one with low CCT LEDs and one with high CCT LEDs, or a filament with a combination of low and high CCT LEDs.

When it is desired to add colours to make a full colour LED filament lamp, the colour LEDs can be added into the lamp as a separate filament. Such a solution, however, suffers from the disadvantage of unpleasant appearance. Alternatively, the colour LEDs may be placed on the same surface of filament substrate together with the white LEDs. However, if RGB and white LEDs strings are formed on the same printed circuit board (PCB) or flexible printed circuit (FPC) surface of the filament, there can be unwanted cross-talk of light between RGB and white strings.

Such a cross-talk will significantly reduce colour-gamut area produced by such a filament in a clear bulb, especially when light emitted by the direct blue LED die is absorbed by red-yellow phosphor layer on top of white line, thus causing unwanted phosphorescence and red-yellow light generation. The red-yellow light emission will cause a shift of filament colour point from pure blue region deeper inside colour space towards less saturated colour points. Such unsaturated colour appearance is disadvantageous for colour tuneable lamps.

One way of reducing optical cross-talk is arranging a light-blocking wall between a first string of white LED dies and a second string of red, green and blue LED dies. However, such a solution suffers from the disadvantage of additional material deposition step for creation of such a light-blocking wall and also requires space on the filament, making the filament very wide, this negatively affecting the aesthetical appearance of the lamp.

Considering the above, there is a need for a LED filament wherein optical cross-talk is reduced or eliminated.

US 2020/212014 discloses an LED filament assembly includes a frame, a first electrode disposed on a first end of the frame, and a second electrode disposed on a second end of the frame. The LED filament assembly includes a first group of LED chips capable of emitting a first color, a second group of LED chips capable of emitting a second color, and a third group of LED chips capable of emitting a third color. The first group of LED chips is disposed on the frame along a longitudinal axis, connected in series, and electrically connected to the first electrode and the second electrode. Similarly, the second and the third group of LED chips are also disposed on the frame along the longitudinal axis, connected in series, and electrically connected to the first electrode and the second electrode. A lamp including such an LED filament assembly is also disclosed.

### SUMMARY OF THE INVENTION

The present invention thus provides a LED filament according to claim 1. The LED filament according to the present invention has a longitudinal extension and a transverse extension being perpendicular to the longitudinal extension. The LED filament further comprises at least one first LED filament portion extending in the longitudinal extension of the LED filament and comprising a plurality of first LED dies adapted to emit first LED light. The first LED dies are encapsulated by a first encapsulant comprising a luminescent material. Such a luminescent material may be a phosphor. A phosphor is a solid material which emits visible light when exposed to radiation from a deep blue, ultra-violet, or electron beam source. Through careful tuning of the phosphor composition and structure, the spectral content of the emitted light can be tailored to meet certain performance criteria. Most white LEDs consist of a LED chip, which emits blue light with a narrow spectrum between 440 - 470 nm, and a coating of yellow, green, and/or red phosphors. The phosphors are designed to absorb some of the blue light from the LED die. The light emitted by the phosphor, in combination with the remaining blue light leaking through the phosphor layer, result in a light which is perceived as white by the human eye.

The first LED dies may be white LED dies for emitting first white LED filament light. The white LED dies may be blue and/or UV LED chips encapsulated by a first encapsulant comprising a luminescent material adapted to at least partly convert blue and/or UV LED light into converted LED light.

Preferably, the LED filament has a length L and a width W, wherein L>5W. The LED filament may be arranged in a straight configuration or in a non-straight configuration such as for example a curved configuration, a 2D/3D spiral or a helix. Preferably, the LED dies are arranged on an elongated carrier like for instance a substrate, that may be rigid (made from e.g. a polymer, glass, quartz, metal or sapphire) or flexible (e.g. made of a polymer or metal e.g. a film or foil). In case the carrier comprises a first major surface and an opposite second major surface, the LED dies are arranged on at least one of these surfaces. The carrier may be reflective or light transmissive, such as translucent and preferably transparent. The LED filament may comprise an encapsulant at least partly covering at least part of the plurality of LED dies. The encapsulant may also at least partly cover at least one of the first major or second major surface. The encapsulant may be a polymer material which may be flexible such as for example a silicone. Further, the LED dies may be arranged for emitting LED light e.g. of different colors or spectrums, as will be described in greater detail below. The LED filament may comprise multiple sub-filaments.

The LED filament of the present invention thus provides a greatly reduced optical cross-talk without the unwanted effect of widening the filament or complicated/expensive manufacturing techniques. The reduced or prevented unwanted intra-filament optical cross-talk of the LED filament can have an unreduced colour-gamut area and/or can achieve saturated color points. Light emitted by direct blue LED dies is prevented from being absorbed by the first encapsulant/luminescent material encapsulating the first LED dies, which otherwise would have caused unwanted phosphorescence and unwanted red-yellow light generation.

The performance of a white LED, including its long-term reliability, is strongly dependent on the choice of phosphor materials as well as the method used to integrate those materials into the LED. Commercially available yellow phosphors typically offer good broadband emission in the visible spectral region (500 - 700 nm), efficient absorption of blue light (420 - 480 nm) and good chemical and thermal stability. However, the emission spectrum of these yellow phosphors lacks content in the red regime. Consequently, white LEDs, with yellow phosphors only, are often characterized by a bluish-white tinge and a CCT ranging between 4000K and 6500K. In addition, these LEDs often do not meet minimum CRI requirements, which is important for illumination-grade LEDs.

Recent advances in red phosphor materials have yielded warm white LEDs with CCT values ranging between 2700K and 4000K, and minimum CRI values of 80. These improvements in color point and color rendering properties have made white LEDs more competitive with other traditional light sources such as incandescent and halogen bulbs. However, warm white LEDs are still less efficient than cool white LEDs because a large portion of the red phosphor emission occurs above 700 nm, which is beyond the sensitivity of the human eye. Minimum CRI values of 90 can be obtained by incorporating even redder phosphor materials at the expense of even less emission below 700 nm, reducing the overall LED efficacy even further.

The LED filament of the present invention further comprises at least one second LED filament portion parallel to the first LED filament portion and comprising a plurality of red, green, and blue LED dies adapted to emit second LED light comprising at least one of red, green and blue light.

The first LED filament portion may comprise a first elongated carrier, wherein the second LED filament portion comprises a second elongated carrier, and wherein the first elongated carrier may be mechanically connected to the second elongated carrier.

The plurality of red, green, and blue LED dies are arranged in rows running in the transverse direction and spaced apart in the longitudinal direction, wherein each row comprises at least three LED dies, and wherein at least one of the red LED die and the green LED die is arranged between each blue LED die and the first LED filament portion in order to reduce or prevent optical cross-talk between the first encapsulant and the second LED light. Each first LED die may be arranged in the same row as the red, green and blue LED die, or may be arranged offset from the row.

Each row comprises at least three LED dies, e.g. a blue LED die, a red LED die and a green LED die. In particular, each blue LED die in each row is arranged between two LED dies selected from a green LED die and a red LED die. Alternatively, each row may comprise a blue LED die and two red LED dies, or a blue LED die and two green LED dies. Each row may comprise same or different LED dies. Further, the order of LED dies in each row may be same or different, as long as there is at least one red LED die or green LED die between each blue LED die and the first LED filament portion.

The present invention thus proposes a special configuration of the LED dies, wherein the blue LED dies are shielded by the red and/or green LED dies, such that a large portion of the blue light that would normally reach the encapsulant is reflected or absorbed, such that it cannot excite the luminescent material of the encapsulant, thus minimizing or eliminating optical cross-talk.

The object of the present invention is to shield the light that could lead to extra conversion by the encapsulant on the first LED dies. Usually, this is blueish light. Accordingly, the die that emits light that could add to extra conversion is arranged as far as possible from the encapsulant on top of the first LED dies.

The plurality of first LED dies may be arranged on a surface of the first LED filament portion, wherein the plurality of red, green and blue LED dies are arranged on a corresponding surface of the second LED filament portion such that the first LED dies are aimed in substantially the same direction(s) as the red, green and blue LED dies.

Each LED die of the plurality of red, green, and blue LED dies has a longitudinal extension. In a particular embodiment, the longitudinal extension of the blue LED dies is equal to or smaller than the longitudinal extension of the red LED dies and the green LED dies. According to such an embodiment, improved shielding of the blue LED dies is obtained, thus minimizing optical cross-talk.

Further, each LED die of the plurality of red, green, and blue LED dies may have a height in a direction being substantially perpendicular to the longitudinal direction and the transverse direction. The height of the blue LED may be equal to or smaller than the height of the red LED dies and the green LED dies. In such an embodiment, the red and green LED dies arranged on either side of the blue LED dies provide an improved shielding of the blue LED dies, thus minimizing optical cross-talk.

Preferably, red and green LED dies have both greater longitudinal extension and greater height compared to the blue LED dies, thus increasing the shielding properties of these dies and reducing the optical cross-talk even further.

Each LED of the plurality of first LED dies may have a height in a direction being substantially perpendicular to the longitudinal direction and the transverse direction. The height of the red LED dies and the green LED dies may than be equal to or greater than the height of the first LED dies including any encapsulation thereof. According to such an embodiment, improved shielding is obtained thus minimizing optical cross-talk.

Each LED die of the red LED dies and the green LED dies may be different from each LED die of the blue LED dies.

The plurality of first LED dies may emit blue and/or UV light and are encapsulated by an encapsulant comprising a luminescent material adapted to at least partly convert the blue and/or UV light into converted white LED light.

In particular, the plurality of first LED dies may emit light the wavelength range from 440 nm to 470 nm.

The LED filament of the present invention further comprises a third LED filament portion parallel to the first and the second LED filament portions and comprising a plurality of third LED dies adapted to emit third LED light. The plurality of third LED dies are encapsulated by a second encapsulant comprising a luminescent material. Such a second encapsulant may comprise same or different material compared to the first encapsulant encapsulating the first LED dies. Preferably, both encapsulants comprise the same material.

The third LED dies may be white LED dies for emitting third white LED filament light of a different color temperature than the first white LED filament light. This gives the possibility to create different color temperatures as well as coloured light using the same LED filament (without crosstalk). The color temperature CT1 of the first white LED filament light could be <2500K, e.g. 2200K. The color temperature CT2 of the third white LED filament light could be >2700K, e.g. 3500K. The difference between CT2 and CT1 could be greater than 500K (CT2-CT1>500K). In particular, the first white LED light may have a colour temperature CT1 of below 2700K, and the third white LED light may have a colour temperature CT2 of at least 3000K.

In a preferred embodiment, the three LED filament portions provide: warm white WW + RGB + cool white CW. In other embodiments, the order could be warm white WW + cool white CW + RGB or cool white CW + warm white WW + RGB. In these embodiments (and in the above-mentioned preferred embodiment), whites of 2 CCT types may be separated from each other, and any white CCT string may be separated from individual red, green, and blue LED dies.

The second LED filament portion is arranged between the first and the third LED filament portions. In other words, the red, green and blue LED dies are arranged between the white LED dies. According to the invention, each row comprises at least three LED dies, wherein at least one of the red LED die and the green LED die is arranged between each blue LED die and the first LED filament portion and between each blue LED die and the third LED filament portion in order to reduce or prevent optical cross-talk between the first encapsulant and the second LED light, and between the second encapsulant and the second LED light. Each row may comprise a blue LED die, a red LED die and a green LED die. In particular, each blue LED die in each row is arranged between two LED dies selected from a green LED die and a red LED die. Alternatively, each row may comprise a blue LED die and two red LED dies, or a blue LED die and two green LED dies. Each row may comprise same or different LED dies. Further, the order of LED dies in each row may be same or different, as long as there is at least one red LED die or green LED die between each blue LED die and the first and third LED filament portions.

Alternatively, (not claimed) the third LED filament portion may be arranged between the first and the second LED filament portions. In such an embodiment, the white LED dies are arranged next to each other.

The present invention further relates to a LED filament lamp comprising at least one LED filament as described above, a light transmissive envelope at least partly surrounding the at least one LED filament; and a connector (104) for electrically and mechanically connecting the LED filament lamp to a socket. The LED filament lamp may for example be retrofit light bulb. The LED filament lamp could further comprise a controller for individually controlling the LED filament portions of the LED filament(s). The LED filament lamp could be color and/or color temperature tuneable.

Finally, the present invention relates to a method of manufacturing an LED filament having reduced optical cross-talk according to claim 12. The method comprises the steps of:
providing at least one first LED filament portion extending in the longitudinal extension of the LED filament and comprising a plurality of first LED dies adapted to emit first LED light, said plurality of first LED dies being encapsulated by a first encapsulant comprising a luminescent material;
providing at least one second LED filament portion parallel to the first LED filament portion and comprising a plurality of red, green, and blue LED dies adapted to emit second LED light comprising at least one of red, green and blue light; and
arranging the plurality of red, green, and blue LED dies in rows running in the transverse direction and spaced apart in the longitudinal direction, wherein each row comprises at least two LED dies, and wherein each blue LED die in each row is arranged between two LED dies selected from a green LED die and a red LED.

This aspect may exhibit the same or similar features and technical effects as any of the previous aspects, and vice versa. For example, to achieve the aforementioned fin-like wall segments with isosceles trapezoid profiles, the at least one substantially flat layer may be segmented into bow tie shaped segments.

It is noted that the invention relates to all possible combinations of features recited in the claims.

### BRIEF DESCRIPTION OF THE DRAWINGS

This and other aspects of the present invention will now be described in more detail, with reference to the appended drawings showing embodiment(s) of the invention.
Fig. 1a is a cross-sectional view along the width of an LED filament according to an embodiment of the present invention.
Fig. 1b is a cross-sectional view along the width of an LED filament according to another embodiment of the present invention;
Fig. 2a is a top view of e.g. the LED filament of Fig. 1a;
Fig. 2b is a top view of the LED filament according to another embodiment of the present invention;

As illustrated in the figures, the sizes of layers and regions may be exaggerated for illustrative purposes and, thus, are provided to illustrate the general structures of embodiments of the present invention. Like reference numerals refer to like elements throughout.

### DETAILED DESCRIPTION

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and fully convey the scope of the invention to the skilled person.

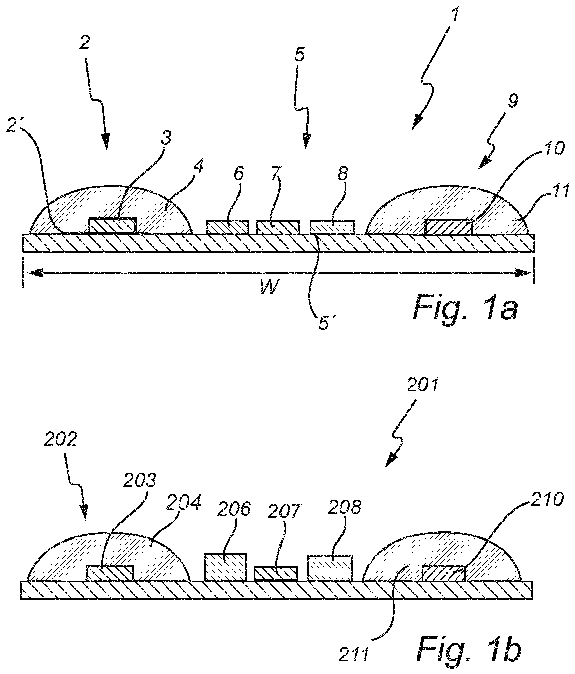

Fig. 1 shows a LED filament 1 having a longitudinal extension L and a transverse extension (or width) W being perpendicular to the longitudinal extension L. The LED filament 1 further comprises a first LED filament portion 2 extending in the longitudinal extension L of the LED filament 1 and comprising a plurality of first LED dies 3 adapted to emit first LED light. The first LED dies 3 are encapsulated by a first encapsulant 4 comprising a luminescent material. Such a luminescent material may be a phosphor.

The first LED dies 3 may be white LED dies for emitting first white LED filament light. The white LED dies may be blue and/or UV LED chips encapsulated by a first encapsulant 4 comprising a luminescent material adapted to at least partly convert blue and/or UV LED light into converted LED light.

The LED filament 1 further comprises a second LED filament portion 5 parallel to the first LED filament portion 2 and comprising a plurality of red, green, and blue LED dies 6, 7, 8 adapted to emit second LED light comprising at least one of red, green and blue light.

The plurality of red, green, and blue LED dies 6, 7, 8 are arranged in rows running in the transverse direction W and spaced apart in the longitudinal direction L, wherein each row comprises three LED dies- 6, 7, 8, and wherein each blue LED die 7 in the each row is arranged between two LED dies selected from a green LED die 6 and a red LED die 8 in order to reduce or prevent optical cross-talk between the first encapsulant 4 and the second LED light.

The present invention thus proposes a special configuration of the LED dies, wherein the blue LED dies 7 are shielded by the red and green LED dies 6, 8, such that a large portion of the blue light that would normally reach the first encapsulant 4 is reflected or absorbed, such that it cannot excite the luminescent material of the first encapsulant 4, thus minimizing or eliminating optical cross-talk. The object of the present invention is to shield the light that could lead to extra conversion by the first encapsulant 4 on the first LED dies 3.

The plurality of first LED dies 3 is arranged on a surface 2' of the first LED filament portion 2, wherein the plurality of red, green and blue LED dies 6, 7, 8 are arranged on a corresponding surface 5' of the second LED filament portion 5 such that the first LED dies 3 are aimed in substantially the same direction(s) as the red, green and blue LED dies, 6, 7, 8.

The LED filament 1 further comprises a third LED filament portion 9 parallel to the first and the second LED filament portions 2, 5 and comprising a plurality of third LED dies 10 adapted to emit third LED light. The plurality of third LED dies are encapsulated by a second encapsulant 11.

The second LED filament portion 5 is arranged between the first and the third LED filament portions 2, 9. In other words, the red, green and blue LED dies 6, 7, 8 are arranged between the white LED dies 3, 10.

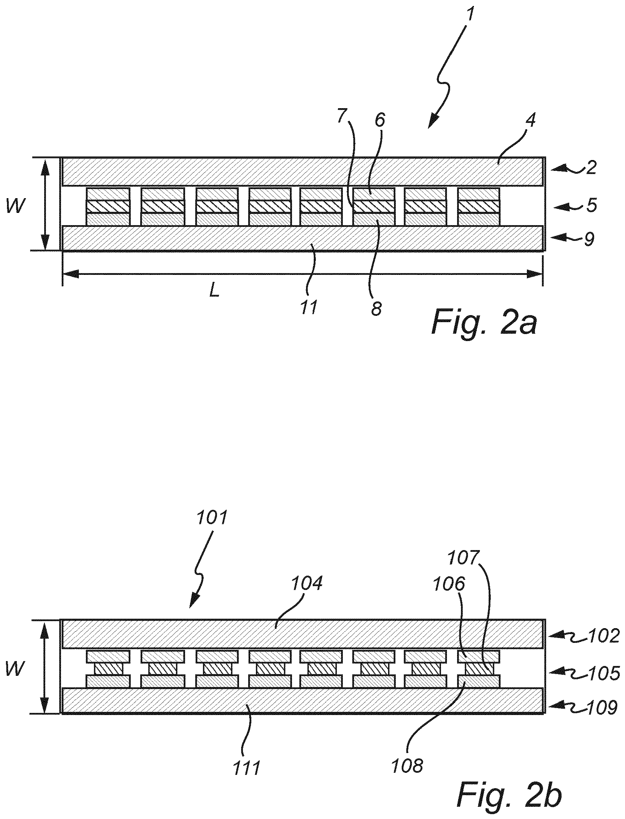

Each LED die of the plurality of red, green, and blue LED dies 6, 7, 8 has a longitudinal extension, as depicted in Fig. 2a. In a particular embodiment shown in Fig. 2b, the longitudinal extension of the blue LED dies 107 is smaller than the longitudinal extension of the red LED dies 106 and the green LED dies 108. According to such an embodiment, improved shielding of the blue LED dies 107 is obtained, thus minimizing optical cross-talk.

Further, each LED die of the plurality of red, green, and blue LED dies 206, 207, 208 may have a height in a direction being substantially perpendicular to the longitudinal direction L and the transverse direction W, as shown in Fig. 1b. The height of the blue LED dies 207 is smaller than the height of the red LED dies 206 and the green LED dies 208. In such an embodiment, the red and green LED dies 206, 208 arranged on either side of the blue LED dies 207 provide an improved shielding of the blue LED dies 207, thus minimizing optical cross-talk.

As mentioned above, the three LED filament portions 2, 5, 9 may provide: warm white WW + RGB + cool white CW, warm white WW + cool white CW + RGB or cool white CW + warm white WW + RGB.

It is noted that the invention relates to all possible combinations of features recited in the claims.

The person skilled in the art realizes that the present invention by no means is limited to the preferred embodiments described above. On the contrary, many modifications and variations are possible within the scope of the appended claims.

Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. A LED filament (1) having a longitudinal extension (L) and a transverse extension (W) being perpendicular to said longitudinal extension (L), said LED filament (1) comprising:
at least one first LED filament portion (2) extending in said longitudinal extension (L) of said LED filament (1) and comprising a plurality of first LED dies (3) adapted to emit first LED light, said first LED dies (3) being encapsulated by a first encapsulant (4) comprising a luminescent material;
at least one second LED filament portion (5) parallel to the first LED filament portion (2) and comprising a plurality of red, green, and blue LED dies (6, 7, 8) adapted to emit second LED light comprising at least one of red, green and blue light;
a third LED filament portion (9) parallel to said first and said second LED filament portions (2, 5) and comprising a plurality of third LED dies (10) adapted to emit third LED light, said third LED dies (3) being encapsulated by a second encapsulant (11) comprising a luminescent material;
wherein said plurality of red, green, and blue LED dies (6, 7, 8) are arranged in rows running in said transverse direction (W) and spaced apart in said longitudinal direction (L),
wherein said second LED filament portion (5) is arranged between said first and said third LED filament portions (2, 9), and wherein each row comprises at least three LED dies, and wherein at least one of said red LED die and said green LED die (6, 8) is arranged between each blue LED die (7) and said first LED filament portion (2) and between each blue LED die (7) and said third LED filament portion (9) in order to reduce or prevent optical cross-talk between said first encapsulant (4) and the blue light of said second LED light, and between said second encapsulant (11) and the blue light of said second LED light.

2. The LED filament (1) according to claim 1, wherein each LED die of said plurality of red, green, and blue LED dies (6, 7, 8) has a longitudinal extension, and wherein said longitudinal extension of said blue LED dies (7) is equal to or smaller than said longitudinal extension of said red LED dies and said green LED dies (6, 8).

3. The LED filament (1) according to claim 1 or 2, wherein each LED die of the plurality of red, green, and blue LED dies (6, 7, 8) has a height in a direction being substantially perpendicular to said longitudinal direction (L) and said transverse direction (W), and wherein said height of said blue LED die (7) is equal to or smaller than said height of said red LED dies and said green LED dies (6, 8).

4. The LED filament (1) according to any one of the preceding claims, wherein each LED die of said red LED dies and said green LED dies (6, 8) is different from each LED die of said blue LED dies (7).

5. The LED filament (1) according to any one of the preceding claims, wherein each LED of said plurality of first LED dies (3) has a height in a direction being substantially perpendicular to said longitudinal direction (L) and said transverse direction (W), and wherein the height of said red LED dies and said green LED dies (6, 8) is equal to or greater than said height of said first LED dies (3) including any encapsulation thereof.

6. The LED filament (1) according to any one of the preceding claims, wherein said plurality of first LED dies (3) emit blue and/or UV light, and wherein said first encapsulant (4) comprises a luminescent material adapted to at least partly convert said blue and/or UV light into converted white LED light.

7. The LED filament (1) according to claim 6, wherein said plurality of first LED dies (3) emit light the wavelength range from 440 nm to 470 nm.

8. The LED filament according to any one of the preceding claims, wherein said third LED filament portion (9) is arranged between said first and said second LED filament portions (2, 5).

9. The LED filament (1) according to any one of the preceding claims, wherein said third LED dies (10) are white LED dies for emitting third white LED light of a different color temperature than said first white LED light.

10. The LED filament (1) according to claim 9, wherein said first white LED light has a colour temperature CT1 of below 2700K, and wherein said third white LED light has a colour temperature CT2 of at least 3000K.

11. A LED filament lamp, comprising:
at least one LED filament (1) according to any one of the preceding claims;
a light transmissive envelope at least partly surrounding said at least one LED filament; and
a connector for electrically and mechanically connecting the LED filament lamp to a socket.

12. A method of manufacturing an LED filament (1) having reduced optical cross-talk and comprising a longitudinal extension (L) and a transverse extension (W) being perpendicular to said longitudinal extension (L), wherein the method comprises:
providing at least one first LED filament portion (2) extending in said longitudinal extension (L) of said LED filament (1) and comprising a plurality of first LED dies (3) adapted to emit first LED light, said plurality of first LED dies (3) being encapsulated by a first encapsulant (4) comprising a luminescent material;
providing at least one second LED filament portion (5) parallel to the first LED filament portion (2) and comprising a plurality of red, green, and blue LED dies (6, 7, 8) adapted to emit second LED light comprising at least one of red, green and blue light;
providing a third LED filament portion (9) parallel to said first and said second LED filament portions (2, 5) and comprising a plurality of third LED dies (10) adapted to emit third LED light, said third LED dies (3) being encapsulated by a second encapsulant (11) comprising a luminescent material; and
arranging said plurality of red, green, and blue LED dies (6, 7, 8) in rows running in said transverse direction (W) and spaced apart in said longitudinal direction (L), wherein said second LED filament portion (5) is arranged between said first and said third LED filament portions (2, 9), and wherein each row comprises at least three LED dies, and wherein at least one of said red LED die and said green LED die (6, 8) is arranged between each blue LED die (7) and said first LED filament portion (2) and between each blue LED die (7) and said third LED filament portion (9) in order to reduce or prevent optical cross-talk between said first encapsulant (4) and the blue light of said second LED light, and between said second encapsulant (11) and the blue light of said second LED light.

## Patentansprüche

1. LED-Filament (1), das eine Längserstreckung (L) und eine Quererstreckung (W), die senkrecht zu der Längserstreckung (L) ist, aufweist, das LED-Filament (1) umfassend:
mindestens einen ersten LED-Filamentabschnitt (2), der sich in die Längserstreckung (L) des LED-Filaments (1) erstreckt und umfassend eine Vielzahl von ersten LED-Chips (3), die angepasst sind, um erstes LED-Licht zu emittieren, wobei die ersten LED-Chips (3) durch ein erstes Verkapselungsmittel (4), umfassend einen Leuchtstoff, verkapselt sind;
mindestens einen zweiten LED-Filamentabschnitt (5) parallel zu dem ersten LED-Filamentabschnitt (2) und umfassend eine Vielzahl von roten, grünen und blauen LED-Chips (6, 7, 8), die angepasst sind, um zweites LED-Licht, umfassend mindestens eines von rotem, grünem und blauem Licht, zu emittieren;
einen dritten LED-Filamentabschnitt (9) parallel zu dem ersten und dem zweiten LED-Filamentabschnitt (2, 5) und umfassend eine Vielzahl von dritten LED-Chips (10), die angepasst sind, um drittes LED-Licht zu emittieren, wobei die dritten LED-Chips (3) durch ein zweites Verkapselungsmittel (11), umfassend einen Leuchtstoff, verkapselt sind;
wobei die Vielzahl von roten, grünen und blauen LED-Chips (6, 7, 8) in Reihen, die in die Querrichtung (W) verlaufen und in die Längsrichtung (L) beabstandet sind, angeordnet sind,
wobei der zweite LED-Filamentabschnitt (5) zwischen dem ersten und dem dritten LED-Filamentabschnitt (2, 9) angeordnet ist, und wobei jede Reihe mindestens drei LED-Chips umfasst, und wobei mindestens einer von dem roten LED-Chip und dem grünen LED-Chip (6, 8) zwischen jedem blauen LED-Chip (7) und dem ersten LED-Filamentabschnitt (2) und zwischen jedem blauen LED-Chip (7) und dem dritten LED-Filamentabschnitt (9) angeordnet ist, um optisches Übersprechen zwischen dem ersten Verkapselungsmittel (4) und dem blauen Licht des zweiten LED-Lichts und zwischen dem zweiten Verkapselungsmittel (11) und dem blauen Licht des zweiten LED-Lichts zu reduzieren oder zu verhindern.

2. LED-Filament (1) nach Anspruch 1, wobei jeder LED-Chip der Vielzahl von roten, grünen und blauen LED-Chips (6, 7, 8) eine Längserstreckung aufweist, und wobei die Längserstreckung der blauen LED-Chips (7) gleich oder kleiner als die Längserstreckung der roten LED-Chips und der grünen LED-Chips (6, 8) ist.

3. LED-Filament (1) nach Anspruch 1 oder 2, wobei jeder LED-Chip der Vielzahl von roten, grünen und blauen LED-Chips (6, 7, 8) eine Höhe in eine Richtung, die im Wesentlichen senkrecht zu der Längsrichtung (L) und der Querrichtung (W) ist, aufweist, und wobei die Höhe des blauen LED-Chips (7) gleich oder kleiner als die Höhe der roten LED-Chips und der grünen LED-Chips (6, 8) ist.

4. LED-Filament (1) nach einem der vorstehenden Ansprüche, wobei jeder LED-Chip der roten LED-Chips und der grünen LED-Chips (6, 8) von jedem LED-Chip der blauen LED-Chips (7) verschieden ist.

5. LED-Filament (1) nach einem der vorstehenden Ansprüche, wobei jede LED der Vielzahl von ersten LED-Chips (3) eine Höhe in eine Richtung, die im Wesentlichen senkrecht zu der Längsrichtung (L) und der Querrichtung (W) ist, aufweist, und wobei die Höhe der roten LED-Chips und der grünen LED-Chips (6, 8) gleich oder größer als die Höhe der ersten LED-Chips (3) einschließlich einer beliebigen Verkapselung davon ist.

6. LED-Filament (1) nach einem der vorstehenden Ansprüche, wobei die Vielzahl von ersten LED-Chips (3) blaues und/oder UV-Licht emittieren, und wobei das erste Verkapselungsmittel (4) einen Leuchtstoff, der angepasst ist, um das blaue und/oder UV-Licht mindestens teilweise in umgewandeltes weißes LED-Licht umzuwandeln, umfasst.

7. LED-Filament (1) nach Anspruch 6, wobei die Vielzahl von ersten LED-Chips (3) Licht in dem Wellenlängenbereich von 440 nm bis 470 nm emittieren.

8. LED-Filament nach einem der vorstehenden Ansprüche, wobei der dritte LED-Filamentabschnitt (9) zwischen dem ersten und dem zweiten LED-Filamentabschnitt (2, 5) angeordnet ist.

9. LED-Filament (1) nach einem der vorstehenden Ansprüche, wobei die dritten LED-Chips (10) weiße LED-Chips zum Emittieren dritten weißen LED-Lichts mit einer Farbtemperatur die von dem ersten weißen LED-Licht verschieden ist, sind.

10. LED-Filament (1) nach Anspruch 9, wobei das erste weiße LED-Licht eine Farbtemperatur CT1 von unter 2700 K aufweist, und wobei das dritte weiße LED-Licht eine Farbtemperatur CT2 von mindestens 3000 K aufweist.

11. LED-Filamentlampe, umfassend:
mindestens ein LED-Filament (1) nach einem der vorstehenden Ansprüche;
eine lichtdurchlässige Hülle, die das mindestens eine LED-Filament mindestens teilweise umhüllt; und
einen Verbinder zum elektrischen und mechanischen Verbinden der LED-Filamentlampe mit einer Fassung.

12. Verfahren zum Herstellen eines LED-Filaments (1), das reduziertes optisches Übersprechen aufweist und umfassend eine Längserstreckung (L) und eine Quererstreckung (W), die senkrecht zu der Längserstreckung (L) ist, wobei das Verfahren umfasst:
Bereitstellen mindestens eines ersten LED-Filamentabschnitts (2), der sich in die Längserstreckung (L) des LED-Filaments (1) erstreckt und umfassend eine Vielzahl von ersten LED-Chips (3), die angepasst sind, um erstes LED-Licht zu emittieren, wobei die Vielzahl von ersten LED-Chips (3) durch ein erstes Verkapselungsmittel (4), umfassend einen Leuchtstoff, verkapselt sind;
Bereitstellen mindestens eines zweiten LED-Filamentabschnitts (5) parallel zu dem ersten LED-Filamentabschnitt (2) und umfassend eine Vielzahl von roten, grünen und blauen LED-Chips (6, 7, 8), die angepasst sind, um zweites LED-Licht, umfassend mindestens eines von rotem, grünem und blauem Licht, zu emittieren;
Bereitstellen eines dritten LED-Filamentabschnitts (9) parallel zu dem ersten und dem zweiten LED-Filamentabschnitt (2, 5) und umfassend eine Vielzahl von dritten LED-Chips (10), die angepasst sind, um drittes LED-Licht zu emittieren, wobei die dritten LED-Chips (3) durch ein zweites Verkapselungsmittel (11), umfassend einen Leuchtstoff, verkapselt sind; und
Anordnen der Vielzahl von roten, grünen und blauen LED-Chips (6, 7, 8) in Reihen, die in die Querrichtung (W) verlaufen und in die Längsrichtung (L) beabstandet sind, wobei der zweite LED-Filamentabschnitt (5) zwischen dem ersten und dem dritten LED-Filamentabschnitt (2, 9) angeordnet ist, und wobei jede Reihe mindestens drei LED-Chips umfasst, und wobei mindestens einer von dem roten LED-Chip und dem grünen LED-Chip (6, 8) zwischen jedem blauen LED-Chip (7) und dem ersten LED-Filamentabschnitt (2) und zwischen jedem blauen LED-Chip (7) und dem dritten LED-Filamentabschnitt (9) angeordnet ist, um optisches Übersprechen zwischen dem ersten Verkapselungsmittel (4) und dem blauen Licht des zweiten LED-Lichts und zwischen dem zweiten Verkapselungsmittel (11) und dem blauen Licht des zweiten LED-Lichts zu reduzieren oder zu verhindern.

## Revendications

1. Filament de DEL (1) ayant une extension longitudinale (L) et une extension transversale (W) perpendiculaire à ladite extension longitudinale (L), ledit filament de DEL (1) comprenant :
au moins une première partie de filament de DEL (2) s'étendant dans ladite extension longitudinale (L) dudit filament de DEL (1) et comprenant une pluralité de premières puces de DEL (3) conçues pour émettre une première lumière de DEL, lesdites premières puces de DEL (3) étant encapsulées par un premier encapsulant (4) comprenant un matériau luminescent ;
au moins une deuxième partie de filament de DEL (5) parallèle à la première partie de filament de DEL (2) et comprenant une pluralité de puces de DEL rouges, vertes et bleues (6, 7, 8) conçues pour émettre une deuxième lumière de DEL comprenant au moins une lumière rouge, verte et bleue ;
une troisième partie de filament de DEL (9) parallèle auxdites première et deuxième parties de filament de DEL (2, 5) et comprenant une pluralité de troisièmes puces de DEL (10) conçues pour émettre une troisième lumière de DEL, lesdites troisièmes puces de DEL (3) étant encapsulées par un second encapsulant (11) comprenant un matériau luminescent ;
dans lequel ladite pluralité de puces de DEL rouges, vertes et bleues (6, 7, 8) sont agencées en rangées s'étendant dans ladite direction transversale (W) et espacées dans ladite direction longitudinale (L),
dans lequel ladite deuxième partie de filament de DEL (5) est agencée entre lesdites première et troisième parties de filament de DEL (2, 9), et dans lequel chaque rangée comprend au moins trois puces de DEL, et dans lequel au moins l'une parmi ladite puce de DEL rouge et ladite puce de DEL verte (6, 8) est agencée entre chaque puce de DEL bleue (7) et ladite première partie de filament de DEL (2) et entre chaque puce de DEL bleue (7) et ladite troisième partie de filament de DEL (9) afin de réduire ou d'empêcher une diaphonie optique entre ledit premier encapsulant (4) et la lumière bleue de ladite deuxième lumière de DEL, et entre ledit second encapsulant (11) et la lumière bleue de ladite deuxième lumière de DEL.

2. Filament de DEL (1) selon la revendication 1, dans lequel chaque puce de DEL de ladite pluralité de puces de DEL rouges, vertes et bleues (6, 7, 8) a une extension longitudinale, et dans lequel ladite extension longitudinale desdites puces de DEL bleues (7) est égale ou inférieure à ladite extension longitudinale desdites puces de DEL rouges et desdites puces de DEL vertes (6, 8).

3. Filament de DEL (1) selon la revendication 1 ou 2, dans lequel chaque puce de DEL de la pluralité de puces de DEL rouges, vertes et bleues (6, 7, 8) a une hauteur dans une direction étant sensiblement perpendiculaire à ladite direction longitudinale (L) et à ladite direction transversale (W), et dans lequel ladite hauteur de ladite puce de DEL bleue (7) est égale ou inférieure à ladite hauteur desdites puces de DEL rouges et desdites puces de DEL vertes (6, 8).

4. Filament de DEL (1) selon l'une quelconque des revendications précédentes, dans lequel chaque puce de DEL desdites puces de DEL rouges et desdites puces de DEL vertes (6, 8) est différente de chaque puce de DEL desdites puces de DEL bleues (7).

5. Filament de DEL (1) selon l'une quelconque des revendications précédentes, dans lequel chaque DEL de ladite pluralité de premières puces de DEL (3) a une hauteur dans une direction étant sensiblement perpendiculaire à ladite direction longitudinale (L) et à ladite direction transversale (W), et dans lequel la hauteur desdites puces de DEL rouges et desdites puces de DEL vertes (6, 8) est égale ou supérieure à ladite hauteur desdites premières puces de DEL (3), y compris toute encapsulation de celles-ci.

6. Filament de DEL (1) selon l'une quelconque des revendications précédentes, dans lequel ladite pluralité de premières puces de DEL (3) émettent de la lumière bleue et/ou UV, et dans lequel ledit premier encapsulant (4) comprend un matériau luminescent adapté pour convertir au moins partiellement ladite lumière bleue et/ou UV en lumière de DEL blanche convertie.

7. Filament de DEL (1) selon la revendication 6, dans lequel ladite pluralité de premières puces de DEL (3) émettent de la lumière dans la plage de longueurs d'onde allant de 440 nm à 470 nm.

8. Filament de DEL selon l'une quelconque des revendications précédentes, dans lequel ladite troisième partie de filament de DEL (9) est agencée entre lesdites première et deuxième parties de filament de DEL (2, 5).

9. Filament de DEL (1) selon l'une quelconque des revendications précédentes, dans lequel lesdites troisièmes puces de DEL (10) sont des puces de DEL blanches pour émettre une troisième lumière de DEL blanche d'une température de couleur différente de celle de ladite première lumière de DEL blanche.

10. Filament de DEL (1) selon la revendication 9, dans lequel ladite première lumière de DEL blanche a une température de couleur CT1 inférieure à 2700 K, et dans lequel ladite troisième lumière de DEL blanche a une température de couleur CT2 d'au moins 3000 K.

11. Lampe à filament de DEL, comprenant :
au moins un filament de DEL (1) selon l'une quelconque des revendications précédentes ;
une enveloppe transmettant la lumière entourant au moins en partie ledit au moins un filament de DEL ; et
un connecteur pour connecter électriquement et mécaniquement la lampe à filament de DEL à une douille.

12. Procédé de fabrication d'un filament de DEL (1) ayant une diaphonie optique réduite et comprenant une extension longitudinale (L) et une extension transversale (W) perpendiculaire à ladite extension longitudinale (L), dans lequel le procédé comprend :
la fourniture d'au moins une première partie de filament de DEL (2) s'étendant dans ladite extension longitudinale (L) dudit filament de DEL (1) et comprenant une pluralité de premières puces de DEL (3) conçues pour émettre une première lumière de DEL, ladite pluralité de premières puces de DEL (3) étant encapsulée par un premier encapsulant (4) comprenant un matériau luminescent ;
la fourniture d'au moins une deuxième partie de filament de DEL (5) parallèle à la première partie de filament de DEL (2) et comprenant une pluralité de puces de DEL rouges, vertes et bleues (6, 7, 8) conçues pour émettre une deuxième lumière de DEL comprenant au moins une lumière rouge, verte et bleue ;
la fourniture d'une troisième partie de filament de DEL (9) parallèle auxdites première et deuxième parties de filament de DEL (2, 5) et comprenant une pluralité de troisièmes puces de DEL (10) conçues pour émettre une troisième lumière de DEL, lesdites troisièmes puces de DEL (3) étant encapsulées par un second encapsulant (11) comprenant un matériau luminescent ; et
l'agencement de ladite pluralité de puces de DEL rouges, vertes et bleues (6, 7, 8) en rangées s'étendant dans ladite direction transversale (W) et espacées dans ladite direction longitudinale (L), dans lequel ladite deuxième partie de filament de DEL (5) est agencée entre lesdites première et troisième parties de filament de DEL (2, 9), et dans lequel chaque rangée comprend au moins trois puces de DEL, et dans lequel au moins l'une parmi ladite puce de DEL rouge et ladite puce de DEL verte (6, 8) est agencée entre chaque puce de DEL bleue (7) et ladite première partie de filament de DEL (2) et entre chaque puce de DEL bleue (7) et ladite troisième partie de filament de DEL (9) afin de réduire ou d'empêcher une diaphonie optique entre ledit premier encapsulant (4) et la lumière bleue de ladite deuxième lumière de DEL, et entre ledit second encapsulant (11) et la lumière bleue de ladite deuxième lumière de DEL.
